# EUROPÄISCHE PATENTSCHRIFT

(11) **EP 1 129 050 B1**
(45) Veröffentlichungstag und Bekanntmachung des Hinweises auf die Patenterteilung: **21.05.2003**
(21) Anmeldenummer: 00952884.5
(22) Anmeldetag: 01.07.2000
(51) Int. Cl.: C04B 41/85, H01C 17/065

(54) **PASTE FÜR DEN SIEBDRUCK VON ELEKTRISCHEN STRUKTUREN AUF TRÄGERSUBSTRATEN**
PASTE FOR SCREENPRINTING ELECTRIC STRUCTURES ONTO CARRIER SUBSTRATES
PATE POUR LA SERIGRAPHIE DE STRUCTURES ELECTRIQUES SUR DES SUBSTRATS DE SUPPORT

(30) Priorität: 29.07.1999 DE 19935677
(43) Veröffentlichungstag der Anmeldung: 05.09.2001
(73) Patentinhaber: ROBERT BOSCH GMBH, 70442 Stuttgart (DE)
(72) Erfinder: BECK, Walter, D-88524 Uttenweiler (DE); HENNIG, Joachim, D-72764 Reutlingen (DE); KRÜGER, Klaus, D-72762 Reutlingen (DE)
(86) Internationale Anmeldenummer: DE0002151
(87) Internationale Veröffentlichungsnummer: WO01009060

(56) Entgegenhaltungen:
- CHEMICAL ABSTRACTS, vol. 113, no. 2, 9. Juli 1990 (1990-07-09) Columbus, Ohio, US; abstract no. 11008m, XP000180805 & JP 01 257182 A (MATSUSHITA ELECTRIC INDUSTRIAL CO LTD) 13. Oktober 1989 (1989-10-13)
- PATENT ABSTRACTS OF JAPAN vol. 1997, no. 02, 28. Februar 1997 (1997-02-28) & JP 08 268782 A (TOSHIBA CORP), 15. Oktober 1996 (1996-10-15)

## Beschreibung

### Stand der Technik

Die Erfindung betrifft eine Paste für den Siebdruck von elektrischen Strukturen auf keramischen Trägersubstraten mit den im Oberbegriff des unabhängigen Anspruchs 1 angegebenen Merkmalen.

Derartige Pasten werden in der Dickschichttechnik eingesetzt, um auf keramischen Trägersubstraten elektrische Bauelemente, wie Widerstände, Kondensatorschichten und Isolierglasschichten zwischen Leiterbahnstrukturen, sowie Abdeck- oder Schutzschichten zu erzeugen, welche eine auf dem keramischen Trägersubstrat aufgebrachte elektronische Schaltung nach außen isolieren. Die Zusammensetzung der bekannten Dickschichtpasten ist beispielsweise beschrieben in "Herbert Reichl; Hybridintegration: Technologie u. Entwurf von Dickschichtschaltungen; Hüthig Verlag, Heidelberg, 1988, Seiten 37 bis 63". Die Dickschichtpasten werden im Siebdruckverfahren auf ein Keramiksubstrat aufgedruckt. Die bekannten Pasten bestehen aus einer Mischung von kleinen Feststoffteilchen mit hohem Erweichungspunkt beziehungsweise hoher Sintertemperatur und einem anorganischen Binder, beispielsweise einem Glas mit niedriger Sintertemperatur, welche in einem verdampfbaren organischen Bindemittel dispergiert sind. Die Feststoffteilchen haben typischerweise einen Durchmesser von etwa 0,1 bis 3 µm. Die Dispersionen weisen die Konsistenz einer Paste auf und besitzen eine Rheologie, welche die Paste für den Siebdruck geeignet macht. Die organischen Bindemittel enthalten verschiedene Zusätze wie Lösungsmittel und rheologische Mittel, welche die Druckfähigkeit der Paste vergrößern. Für den Aufdruck von Widerständen werden der Paste außerdem Metalloxide beigemischt, welche die Leitfähigkeit der Widerstandselemente bestimmen. Nach dem Siebdruck werden die aufgedruckten Strukturen in einem Sintervorgang gebrannt, wobei die organischen Bestandteile vollständig aus der Paste verdampfen beziehungsweise pyrolisieren. Bei einer Temperatur unterhalb der Sintertemperatur der Feststoffteilchen aber oberhalb der Sintertemperatur des anorganischen Bindemittels wird letzteres erweicht und umfließt die nicht sinternden Feststoffteilchen. Die nach dem Abkühlen fertiggestellten elektrischen Strukturen weisen ein anderes thermisches Ausdehnungsverhalten auf als das Trägersubstrat. Bei Temperaturschwankungen kommt es daher häufig zu einer Rißbildung in den Widerstandsstrukturen, wodurch die elektrischen Eigenschaften nachteilig beeinflußt werden. Im Extremfall fällt der Widerstand völlig aus. Risse in einer aufgedruckten Abdeckschicht oder Isolationsschicht führen zu einem nachteiligen Eindringen von Schadstoffen beziehungsweise einem Kurzschluß der Leiterbahnen.

### Vorteile der Erfindung

Mit der erfindungsgemäßen Paste für den Siebdruck von elektrischen Strukturen auf keramischen Trägersubstraten wird vorteilhaft die Zugfestigkeit der aufgedruckten Strukturen um einen Faktor Zehn erhöht und die Gefahr einer Rißbildung oder eines Bruchs der Strukturen vermindert. Die Wahrscheinlichkeit eines Ausfalls der auf dem Trägersubstrat erzeugten Schaltung kann hierdurch deutlich verringert werden, was insbesondere in solchen Fällen bedeutsam ist, in denen das Trägersubstrat mit den aufgedruckten Strukturen im Betrieb sehr starken Temperaturwechselbelastungen oder starken beschleunigenden Kräften ausgesetzt wird, wie dies beispielsweise in der Kraftfahrzeugelektronik der Fall ist. Die Bruchzähigkeit und Festigkeit der Strukturen wird durch Fasern erhöht, welche den hochsinternden Feststoffanteil der Siebdruckpaste bilden. Die in die gebrannten Strukturen (Widerstände oder Isolierschichten) eingelagerten Fasern erhöhen dabei die Festigkeit der gebildeten Strukturen. Die Fasern sind aus einem Material gebildet, welches bei der Sintertemperatur des anorganischen Bindemittels nicht sintert. In Frage kommen beispielsweise Keramikfasern oder Fasern aus HT-Glas mit hohem Erweichungspunkt, beziehungsweise hoher Sintertemperatur. Vorteilhaft beträgt die Länge der Fasern wenigstens den fünffachen Wert ihres Durchmessers. Die faserhaltige Paste weist eine gute Druckfähigkeit im Siebdruckverfahren auf, so daß die Strukturen mit der bekannten Siebdrucktechnik auf das Trägersubstrat aufgebracht werden können.

### Beschreibung der Ausführungsbeispiele

Ausführungsbeispiele der Erfindung werden in der nachfolgenden Beschreibung erläutert. Die für den Siebdruck von elektrischen Strukturen auf einem Trägersubstrat verwandte Pasten umfaßt wenigstens folgende Bestandteile:
a) anorganische Faserteilchen mit hoher Sintertemperatur,
b) anorganisches Bindemittel,
C) organische verdampfbare Bindemittel.

Die in der Paste enthaltenen anorganischen Faserteilchen, weisen eine Sintertemperatur auf, die deutlich oberhalb der Sintertemperatur des anorganischen Bindemittels liegt und sintern während des Brennprozesses nicht. Materialien, die hierfür in Frage kommen sind Fasern aus keramischen Feststoffen oder HT-Gläsern mit hohem Erweichungspunkt. Beispielsweise können die Fasern aus BaTiO₃, CaTiO₃, SrTiO₃, PbTiO₃, CaZrO₃, BaZrO₃, CaSnO₃, BaSnO₃, einem Metallcarbid oder einem Metallnitrid, Zirkoniumdioxid oder Siliciumdioxid hergestellt werden. Als HT-Gläser kommen Quarzglas, Borsilikatglas, Aluminiumsilikatglas, Kieselglas und andere Gläser in Frage. In einem bevorzugten Ausführungsbeispiel werden die Fasern aus Al₂O₃-Keramik hergestellt. Derartige Fasern werden im Handel beispielsweise zur Verwendung in Schneidwerkzeugen angeboten. Der Faserdurchmesser sollte zwischen 3 und 10 Mikrometern, die Länge der Fasern zwischen 15 und 100 Mikrometer betragen. Die Länge der Fasern sollte um einen Faktor 5 den Durchmesser übersteigen. Gute Ergebnisse wurden mit Fasern erzielt, deren Länge das fünf- bis zehnfache des Durchmessers beträgt. Der Füllfaktor der Fasern in der Siebdruckpaste sollte bei etwa 2 bis 10 Volumenprozenten liegen. Gegebenenfalls kann die Paste weitere hochsinternde, nicht faserförmige Keramikpartikel oder Partikel aus HT-Glas mit unterschiedlicher Geometrie enthalten.

Als anorganisches Bindemittel werden bekannte Gläser verwandt, deren Sintertemperatur deutlich unterhalb der Sintertempertur der Fasern liegt und die beim Brennen der gedruckten Strukturen einem viskosen Phasensintern unterliegen. Die Teilchengröße liegt zwischen 0,5 und 20 Mikrometern. In Frage kommen amorphe verglasbare oder amorphe kristallisierbare Gläser, wie sie typischerweise als anorganisches Bindemittel in Dickschichtpasten verwandt werden.

Die organischen Bindemittel umfassen den Druckträger und verschiedene Zusätze, wie Weichmacher, beispielsweise Glycerin, und Lösungsmittel, beispielsweise Äthylcellulose oder Terpineol. In Frage kommen im Stand der Technik bekannte polymere Bindemittel für Dickschichtpasten.

Für den Siebdruck der Paste wird ein Sieb mit einer Stegbreite und einem Öffnungsdurchmesser von etwa 20 bis 120 Mikrometern verwandt. Natürlich können auch Druckschablonen eingesetzt werden. Als Trägersubstrat wird ein keramisches Trägersubstrat, beispielsweise aus Al₂O₃-Keramik, oder ein Multilayer-Substrat verwandt.

Für den Siebdruck von Widerständen auf dem Trägersubstrat werden der oben angegebenen Paste Leitmittel beigemischt. Hierfür kann beispielsweise Bleiruthenat Pb₂Ru₂O₆ verwandt werden. Aber auch andere Leitmittelzusätze kommen in Frage, wie beispielsweise Beimischungen von Rutheniumdioxid oder Iridiumoxid/Platin und Palladiumoxid/Silber.

Die Strukturen werden in einer Dicke von 5 bis 50 Mikrometern auf das keramische Trägersubstrat aufgedruckt, getrocknet und anschließend in einem Sinterofen gebrannt. Bei Temperaturen von 400 bis 600°C verdampfen, beziehungsweise pyrolisieren die organischen Bestandteile aus der Paste. Bei Temperaturen zwischen 750 und 1000°C beginnt das anorganische Bindemittel zu erweichen und sintert, wodurch sich die nicht sinternden Faserteilchen mit einem Erweichungspunkt deutlich oberhalb von 1000°C enger anordnen.

Mit der oben angegebenen Zusammensetzung der Siebdruckpaste können verschiedene elektrische Strukturen auf das Trägersubstrat aufgedruckt werden. So können beispielsweise Abdeckschichten auf die Oberseite des keramischen Trägersubstrats aufgebracht werden. Auch ist es möglich, Isolierschichten auf Leiterbahnen aufzudrucken, welche anschließend mit weiteren Leiterbahnen überdeckt werden. Durch die Verwendung von speziellen Zusätzen, wie beispielsweise den oben angegebenen Leitmittelzusätzen können Widerstandselemente aufgedruckt werden. Weiterhin ist es möglich, durch spezielle Pastenzusätze Kondensatorschichten auf dem Trägersubstrat mit der hier vorgestellten Paste aufzudrucken. Der Volumenanteil der Fasern in den gebrannten Strukturen liegt nach dem Abkühlen zwischen 6 und 20 %. Die in den gebrannten Strukturen enthaltenen Fasern bilden quasi ein inneres Gerüst, durch welches die Festigkeit der Strukturen erhöht wird.

## Patentansprüche

1. Paste für den Siebdruck von elektrischen Strukturen auf Trägersubstraten, insbesondere keramischen Trägersubstraten, enthaltend eine in einem verdampfbaren organischen Bindemittel dispergierte Mischung von anorganischen Feststoffteilchen mit hoher Sintertemperatur und einem anorganischen Bindemittel mit einer niedrigen Sintertemperatur unterhalb der Sintertemperatur der anorganischen Feststoffteilchen, **dadurch gekennzeichnet, daß** die anorganischen Feststoffteilchen mit hoher Sintertemperatur wenigstens teilweise in Form von Fasern vorliegen.

2. Paste nach Anspruch 1, **dadurch gekennzeichnet, daß** die Länge der Fasern den Faserdurchmesser wenigstens um einen Faktor fünf übersteigt.

3. Paste nach Anspruch 1 oder 2, **dadurch gekennzeichnet, daß** die Fasern Keramikfasern sind.

4. Paste nach Anspruch 3, **dadurch gekennzeichnet, daß** die Keramikfasern aus Al₂O₃-Keramik hergestellt sind.

5. Paste nach Anspruch 1 oder 2, **dadurch gekennzeichnet, daß** die Fasern Glasfasern sind, welche aus einem hochsinternden Glas mit einem Erweichungspunkt oberhalb der Sintertemperatur des anorganischen Bindemittels hergestellt sind.

6. Paste nach Anspruch 5, **dadurch gekennzeichnet, daß** die Glasfasern aus Borsilikatglas, Aluminiumsilikatglas oder Kieselglas hergestellt sind.

7. Paste nach Anspruch 6, **dadurch gekennzeichnet, daß** die Paste außer den Fasern mit hoher Sintertemperatur zusätzlich nichtfaserartige keramische Partikel mit hoher Sintertemperatur aufweist.

8. Paste nach Anspruch 1, **dadurch gekennzeichnet, daß** der Volumenanteil der Fasern in der Paste zwischen 2 und 10 Prozent liegt.

9. Paste nach einem der vorstehenden Ansprüche, **dadurch gekennzeichnet, daß** die Paste Leitmittelzusätze enthält.

10. Paste nach Anspruch 9, **dadurch gekennzeichnet, daß** die Leitmittel ein Metalloxid umfassen.

11. Trägersubstrat mit elektrischen Strukturen, welche durch Siebdruck auf dem Trägersubstrat mit einer Paste nach einem der Ansprüche 9 oder 10 und durch anschließendes Sintern hergestellt sind, wobei die Strukturen elektrische Widerstände bilden.

12. Trägersubstrat mit elektrischen Strukturen, welche durch Siebdruck auf dem Trägersubstrat mit einer Paste nach einem der Ansprüche 1 bis 8 und anschließendes Sintern hergestellt sind, wobei die Strukturen auf dem Trägersubstrat Abdeckschichten oder Isolierschichten bilden.

## Claims

1. Paste for screen-printing electrical structures onto carrier substrates, in particular ceramic carrier substrates, containing a mixture of inorganic solid particles with a high sintering temperature and an inorganic binder with a low sintering temperature which is lower than the sintering temperature of the inorganic solid particles, dispersed in an evaporable organic binder, **characterized in that** the inorganic solid particles with a high sintering temperature are at least partially in the form of fibres.

2. Paste according to Claim 1, **characterized in that** the length of the fibres exceeds the fibre diameter by a factor of at least five.

3. Paste according to Claim 1 or 2, **characterized in that** the fibres are ceramic fibres.

4. Paste according to Claim 3, **characterized in that** the ceramic fibres are made from Al₂O₃ ceramic.

5. Paste according to Claim 1 or 2, **characterized in that** the fibres are glass fibres which are made from a high-sintering glass with a softening point which is above the sintering temperature of the inorganic binder.

6. Paste according to Claim 5, **characterized in that** the glass fibres are made from borosilicate glass, aluminosilicate glass or silica glass.

7. Paste according to Claim 6, **characterized in that** in addition to the fibres with a high sintering temperature, the paste additionally includes non-fibrous ceramic particles with a high sintering temperature.

8. Paste according to Claim 1, **characterized in that** the fibres form between 2 and 10 per cent by volume of the paste.

9. Paste according to one of the preceding claims, **characterized in that** the paste contains additions of conductive agents.

10. Paste according to Claim 9, **characterized in that** the conductive agents comprise a metal oxide.

11. Carrier substrate with electrical structures which are produced by screen-printing on the carrier substrate using a paste according to one of Claims 9 or 10 and by subsequent sintering, the structures forming electrical resistors.

12. Carrier substrate with electrical structures which are produced by screen-printing on the carrier substrate using a paste according to one of Claims 1 to 8 and subsequent sintering, the structures on the carrier substrate forming covering layers or insulating layers.

## Revendications

1. Pâte de sérigraphie pour réaliser les structures électriques sur des substrats de support, notamment des substrats de support en céramique, comportant un mélange de particules de matière solide anorganique à température de frittage élevée et d'un liant anorganique à température de frittage faible en dessous de la température de frittage des pariticules solides anorganiques, en dispersion dans un liant organique susceptible d'être évaporé,
**caractérisée en ce que**
les particules solides anorganiques à température de frittage élevée sont au moins en partie présentes sous la forme de fibres.

2. Pâte selon la revendication 1,
**caractérisée en ce que**
la longueur des fibres correspond à au moins cinq fois leur diamètre.

3. Pâte selon l'une quelconque des revendications 1 ou 2,
**caractérisée en ce que**
les fibres sont des fibres de céramique.

4. Pâte selon la revendication 3,
**caractérisée en ce que**
les fibres de céramique sont en alumine Al₂O₃.

5. Pâte selon l'une quelconque des revendications 1 ou 2,
**caractérisée en ce que**
les fibres sont des fibres de verre réalisées en un verre à température de frittage élevée, avec un point de ramollissement supérieur à la température de frittage du liant anorganique.

6. Pâte selon la revendication 5,
**caractérisée en ce que**
les fibres de verre sont en verre de borosilicate, en verre de silicate d'aluminium ou en verre de silice.

7. Pâte selon la revendication 6,
**caractérisée en ce qu'**
en dehors des fibres à température de frittage élevée elle contient en outre des particules céramiques non fibreuses à température de frittage élevée.

8. Pâte selon la revendication 1,
**caractérisée en ce que**
la teneur volumique des fibres dans la pâte représente entre 2 et 10 %.

9. Pâte selon l'une quelconque des revendications précédentes,
**caractérisée en ce que**
la pâte contient des additifs d'agents conducteurs.

10. Pâte selon la revendication 9,
**caractérisée en ce que**
les agents conducteurs comprennent un oxyde métallique.

11. Substrat de support à structures électriques réalisé par sérigraphie sur le substrat de support avec une pâte selon l'une quelconque des revendications 9 ou 10, suivi d'un frittage, les structures formant des résistances électriques.

12. Substrat de support à structures électriques réalisé par sérigraphie sur le substrat de support avec une pâte selon l'une quelconque des revendications 1 à 8, suivi d'un frittage, les structures formant sur le substrat de support, des couches de recouvrement ou des couches d'isolation.
